# EUROPEAN PATENT APPLICATION

(11) **EP 2 416 135 A1**
(43) Date of publication of application: **08.02.2012**
(21) Application number: 10758772.7
(22) Date of filing: 31.03.2010
(51) Int. Cl.: G01J 1/02, H01L 35/32, H04N 5/33

(54) **INFRARED ARRAY SENSOR**

(30) Priority: 31.03.2009 JP 2009087009
(71) Applicant: Panasonic Electric Works Co., Ltd., Kadoma-shi, Osaka 571-8686 (JP)
(72) Inventor: TSUJI, Koji, Kadoma-shi Osaka 571-8686 (JP)
(74) Representative: Appelt, Christian W.
(86) International application number: PCT/JP2010/055803
(87) International publication number: WO 2010/114001

(57) **Abstract**

The infrared array sensor comprises a base with recess and a plurality of image elements on the base to cover the recess. The image element has the first infrared absorption members and the thermosensors. The thin film structural body is formed with a slit which divides the thin film structural body into the cantilevers. The cantilever has one lengthwise end which is defined as the first end, and remaining one lengthwise end which is defined as the second end. The thermosensor is disposed on the cantilever. When the temperature variation of the thermosensor is caused, the thermosensor generates the output signal corresponding to the temperature variation of the thermosensor.

## Description

### TECHNICAL FIELD

This invention relates to an infrared array sensor.

### BACKGROUND ART

Japanese patent application publication No. 2001-309122A discloses the prior infrared array sensor. (Japanese patent application publication No. 2011-309122A is hereinafter referred to as patent literature 1.) Conventionally, in various locations, the infrared array sensor is research and developed. The infrared array sensor is manufactured by means of micromachining technology. The infrared array sensor comprises a base and a plurality of image elements. Each the image element is provided with an infrared absorption portion. A plurality of the image elements are arranged on the surface of the base to be arrayed.

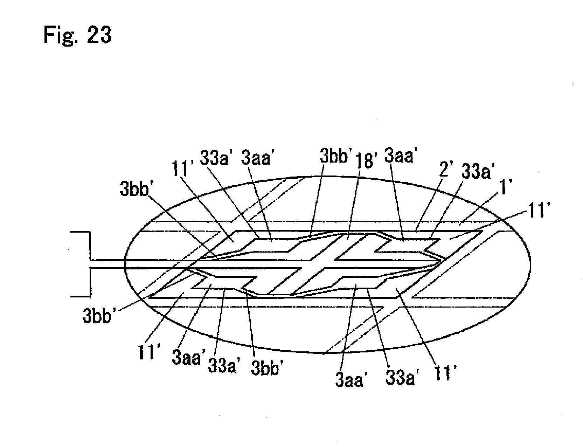

Fig. 23 shows an infrared array sensor disclosed in the patent literature 1'. As will be understood from Fig. 23, the infrared array sensor comprises a base and a plurality of the image elements 2'. It is noted that Fig. 23 shows only one image element. The base 1' is formed by the silicon substrate. A plurality of the image elements 2' are arranged on the surface of the base 1'. Each the image element has an image element forming area. The image element forming area is divided into four sub-areas by the border portion 10' having a cross shape, whereby each the sub-area has a rectangular shape. In addition, the base is formed with a plurality of the recesses 11'. In addition, the image element is disposed on the base 1' such that each the sub-area is located over the recess 11'. In addition, each the sub-area is provided with a sub-thin film structural body 3aa'. In addition, the image element 2' is disposed on the base 1' such that the sub-thin film structural body 3aa' is located in an inside of the rim of the recess 11'.

The sub-thin film structural body 3aa' is configured to hold the infrared absorption portion33a' which has a laminated structure. The infrared absorption portion 33a' comprises a first SiO₂ film, a thermoelement, a second SiO₂ layer, and the infrared absorption film. Specifically, the thermosensor is realized by the metal thin-film resistor (bolometer). The metal thin-film resistor is disposed on the first SiO₂ film. The second SiO₂ film is disposed to cover the thermosensor. The infrared absorption film is disposed on the second SiO₂ film. The infrared absorption portion is coupled to the rim of the recess of the base 1' with the two bridges 3bb'.

In addition, the structure shown in Fig. 23' comprises the thermosensor which is realized by the bolometer. The image element 2' comprises the thermosensing portion which is realized by the four thermoelements which are connected in series, whereby the variation output corresponding to the temperature variation is set to be greater than that in a case where the output is obtained from each the thermosensor. In addition, the patent literature 1 discloses that each the thermosensor may be realized by the thermopile and the pyroelectric element.

In addition, the infrared array sensor is not limited to the above structure. The infrared array with the MOS transistor is also well known. The MOS transistor is used as the switching element for selecting the image element to read out the output of the thermoelement.

### SUMMARY OF INVENTION

### PROBLEM TO BE SOLVED BY THE INVENTION

The configuration of dividing the image element forming area into four sub-areas makes it possible to improve the response speed of the infrared array sensor having the image element 2', compared with the response speed of the infrared array sensor comprises the image element 2' having large one image element forming area. Specifically, the image element 2' comprises the image element forming area which is divided into four sub-areas. With this configuration, the infrared absorption portion of the infrared array sensor is lowered its heat capacity, compared with the heat capacity of the infrared array sensor comprising the image element 2' which is realized by the large one image element forming area. That is, this configuration makes it possible to reduce the time constant (thermal time constant). As a result, the response speed is improved.

However, the image element forming area of the image element 2' of the infrared array sensor is provided at its border portion 18' with no sub-thin film structural body 3aa'. Therefore, the dimension occupied by the sub-thin film structural body 3aa' within the image element 2' is increased. According to this reason, the infrared array sensor encounters the difficulty to improve its sensitivity.

In addition, in the infrared array sensor of Fig. 23, if the infrared absorption portion is enlarged its thickness, the thermal capacity of the infrared absorption portion 33a' is increased. This results in the decrease of the response speed of the infrared array sensor. In response to this problem, it is possible to decrease the thickness of the infrared absorption portion 33a'. However, when the thickness of the infrared absorption portion 33a' is decreased, the infrared array sensor is decreased its sensitivity. In addition, if the thickness of the infrared absorption portion 33a' is decreased, the sub-thin film structural body 33a' tends to occur in the warpage. As a result, the infrared absorption portion 33' is broken at the time of manufacture. Therefore, the extraction rate is decreased. In addition, the stability of the structure is decreased, whereby the sensitivity is decreased. In addition, the infrared array sensor in Fig. 23 comprises the sub-thin film structural body 33a' which is supported by the two linear bridges 3bb' from the both sides of the sub-thin film structural body. Therefore, when the stress and the heat stress is applied to the sub-thin film structural body 3aa' from the base 1' or the outside (such as the mounting substrate adapted to mount the infrared array sensor), there is a possibility that the sub-thin film structural body 3aa' is deformed. This results in the variation of the sensitivity of the infrared array sensor.

This invention is achieved to solve the above object. A first object in this invention is to produce the infrared array sensor which is improved its structural stability. A second object in this invention is to improve the response speed and the sensitivity.

### PROBLEM TO BE SOLVED BY THE INVENTION

In order to solve the above problem, this invention discloses the infrared array sensor which comprises a base and a plurality of image elements. The base has a front surface. The base is provided at its front surface with a plurality of recesses and a plurality of the rims. The rims are located around the recesses, respectively. Each the recess has an inner periphery which is defined by the rim. The image element is disposed on the front surface of the base such that the image element covers the recess. The image element comprises a thin film structural body, a plurality of the first infrared absorption layers, and a plurality of the thermosensors. The thin film structural body is provided with the first slit. The first slit penetrates through the thin film structural body from the rear surface of the thin film structural body to the front surface of the thin film structural body. Consequently, the first slit divides the thin film structural body into a plurality of the cantilevers. The cantilevers are arranged along the rim. The cantilever has a length and a width. The cantilever has one lengthwise end which is defined as a first end and remaining one lengthwise end which is defined as a second end. The cantilever is fixed at its one end to the rim. The first infrared absorption layer is disposed on the cantilever, whereby the first infrared absorption layer is located in a position inside of the inner periphery The first infrared absorption layer is configured to generate heat when the first infrared absorption layer absorbs the infrared. When the first infrared absorption layer generates the heat, the heat is transferred to the thermosensor. The thermosensor is disposed on the cantilever. The thermosensor is configured to generate the output signal corresponding to the temperature variation of the thermosensor when the temperature variation of the thermosensor is caused.

This configuration makes it possible to improve the response speed and the sensitivity. Furthermore, this configuration makes it possible to improve the stability of the structure.

It is preferred that the thermosensors are electrically connected to each other to establish a predetermined connection relationship. According to the predetermined connection relationship, all the thermosensors are set to generate output signal which indicates the temperature variation. The output signal which is generated by all the thermosensors is greater than the output signal which is generated by each the thermosensors.

This configuration also makes it possible to improve the response speed and the sensitivity. Furthermore, this configuration makes it possible to improve the stability of the structure.

It is preferred that all the thermosensors are electrically connected to each other to establish the predetermined connection relationship. Consequently, when the temperature of the thermosensor is varied, the thermosensors are cooperative with each other to sgenerate the second output signal. The second output signal is greater than the output signal.

The thermosensor is preferably realized by the thermopile.

The predetermined connection relationship is preferably realized by the series connection.

The recess is preferably shaped to have a four sided pyramid.

The recess is preferably formed from the rear surface of the base.

The recess is preferably formed to have an inside surface being realized by the concave curve.

The base is preferably provided at its rear surface with an opening portion such that the recesses are communicated with each other by the opening portion.

It is preferred that the cantilever is provided with a second slit which is located between the first end and the second end. The second slit penetrates through the cantilever from the rear surface of the cantilever to the front surface of the cantilever. The second slit is formed such that the second slit is overlapped with the recess in a thickness direction of the base. The first infrared absorption layer is located between the second slit and the second end. The thermopile comprises the thermoelectric couple, the hot junction which is located in one end of the thermoelectric couple, and the cold junction which is located in remaining one end of the thermoelectric couple. The hot junction is located between the second end and the second slit. The cold junction is located between the first end and the second slit.

In this case, it is possible to improve the response speed and the sensitivity. In addition, it is possible to improve the stability of the structure.

The cantilever has a bridge which is located in a position between the second slit and one end of the width direction of the cantilever. In this case, the thermoelectric couple is preferably disposed on the bridge. Consequently, the hot junction is connected to the cold junction through the thermoelectric couple on the bridge.

The hot junction is preferably disposed in a position between the first infrared absorption layer and the second slit.

The infrared array sensor is preferably provided with the second infrared absorption layer. The second infrared absorption layer is disposed between the second slit and the second end. The hot junction is located in a position between the second infrared absorption layer and the first infrared absorption layer.

It is preferred that the second slit extends in a direction cross with the lengthwise direction of the cantilever.

Instead of the above, the cantilever preferably comprises a bridge, a holding plate, and a sub holding plate. In this case, the bridge is attached at its first end with the rim. The bridge extends from the rim toward a center of the inner periphery. Consequently, the bridge has the second end which is opposite of the first end. The holding plate is held by the second end of the bridge such that the holding plate is overlapped with the recess in a thickness direction of the base. The sub holding plate extends toward a first end of the cantilever from the holding plate. The sub holding plate is spaced from the bridge, whereby the cantilever is formed with a second slit which has U-shape. The second infrared absorption layer is held by the sub holding plate, whereby the second infrared absorption layer is located in a position between the second slit and the second end. The thermoelectric couple is disposed on the cantilever such that the thermoelectric couple extends through the bridge.

The cantilever preferably has a width which becomes gradually smaller toward the second end from the first end.

The recess is preferably formed with an opening which is perpendicular to a thickness direction of the base. The opening is shaped to have a hexagonal shape, whereby the rim has six sides. Each one of the first ends of the cantilever is attached to each the side. Each the cantilever extends toward a center of the opening. Each the cantilever is spaced from an adjacent cantilever by the first slit.

### BRIEF EXPLANATION OF DRAWINGS

Fig. 1 shows a planar layout of the image element of the infrared array sensor in the first embodiment.
Fig. 2 shows a planar layout of the image element of the infrared array sensor in the above.
Fig. 3 shows a planar layout of the infrared array sensor of the above.
Fig. 4 A shows a planar layout of the main section of the image element of the infrared array sensor of the above.
Fig. 4 B shows a schematic side cross sectional view taken along the line of D - D in Fig. 4 A of the above.
Fig. 5 shows a planar layout of the main section of the image element of the infrared array sensor of the above.
Fig. 6 shows a planar layout of the main section of the image element of the infrared array sensor of the above.
Fig. 7 A shows a planar layout of the main section of the image element of the infrared array sensor of the above.
Fig. 7 B shows a schematic cross sectional view of the main section of the image element of the infrared array sensor of the above.
Fig. 8 A shows a planar layout of the main section of the image element of the infrared array sensor of the above.
Fig. 8 B shows a schematic cross sectional view of the main section of the image element of the infrared array sensor of the above.
Fig. 9 shows a schematic cross sectional view of the main section of the image element of the infrared array sensor of the above.
Fig. 10 shows a schematic cross sectional view of the main section of the image element of the infrared array sensor of the above.
Fig. 11 shows a equivalent circuit of the infrared array sensor of the above.
Fig. 12 shows a planar layout of another image element of the infrared array sensor of the above.
Fig. 13 shows a schematic cross sectional view of the infrared module comprising the infrared array sensor of the above.
Fig. 14 shows a cross sectional view for explaining the process of manufacturing the infrared array sensor of the above.
Fig. 15 shows a cross sectional view for explaining the process of manufacturing the infrared array sensor of the above.
Fig. 16 shows a cross sectional view for explaining the process of manufacturing the infrared array sensor of the above.
Fig. 17 shows a cross sectional view for explaining the process of manufacturing the infrared array sensor of the above.
Fig. 18 shows a schematic cross sectional view of the image element in the infrared array sensor of the second embodiment.

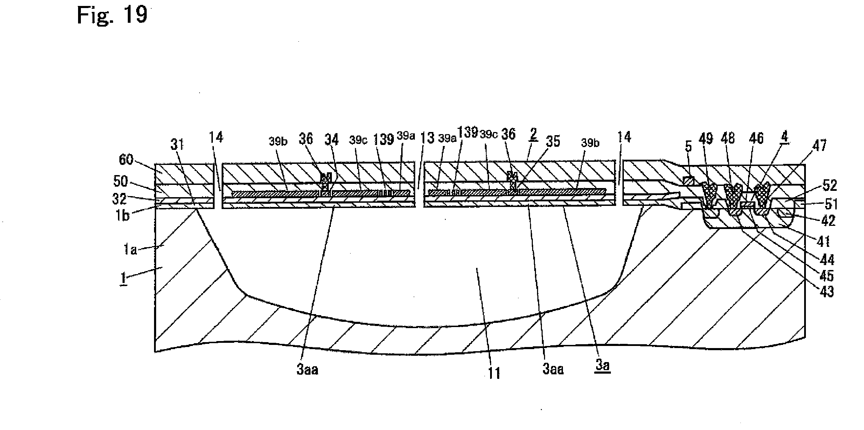

Fig. 19 shows a schematic cross sectional view of the image element in the infrared array sensor of the third embodiment.
Fig. 20 shows a schematic cross sectional view of the image element in the infrared array sensor of the fourth embodiment.
Fig. 21 shows a planar layout of the image element in the infrared array sensor of the fifth embodiment.
Fig. 22 shows an expanded illustration of the main section of the planar layout of the image element of the above.
Fig. 23 shows a schematic perspective view of the main section of the infrared array sensor of the prior art.

### BEST MODE FOR CARRYING OUT THE INVENTION

### (FIRST EMBODIMENT)

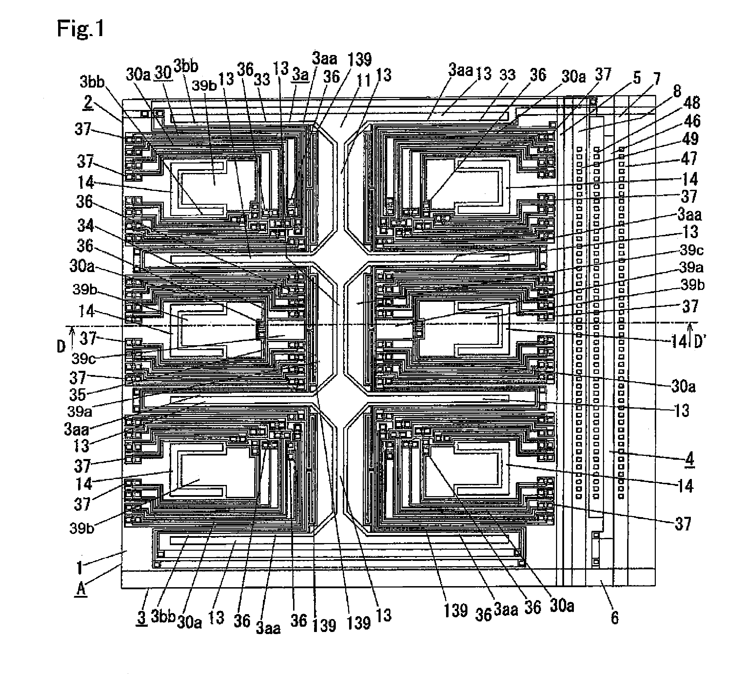

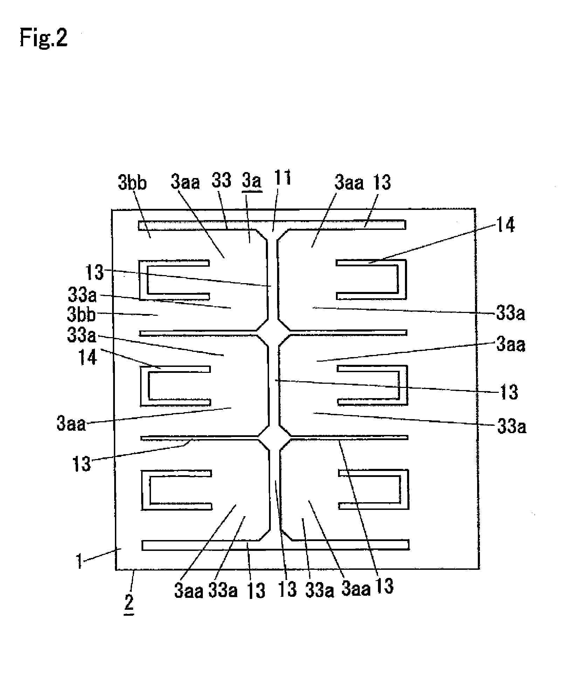

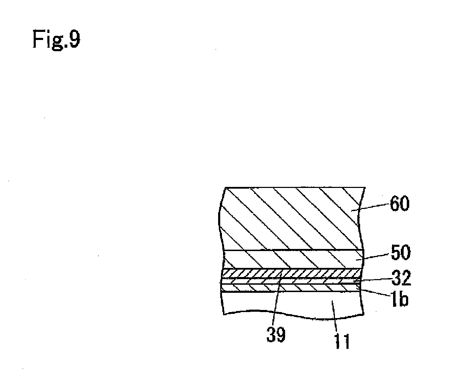

Hereinafter the explanation of the infrared array in this embodiment is made with Fig. 1 to Fig. 13.

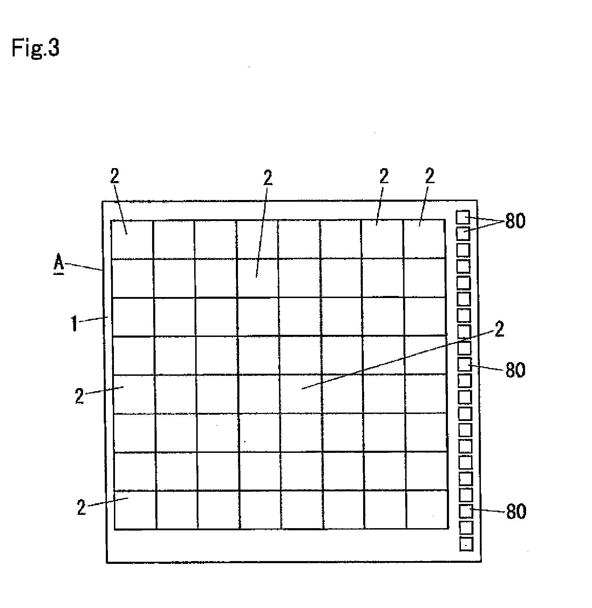

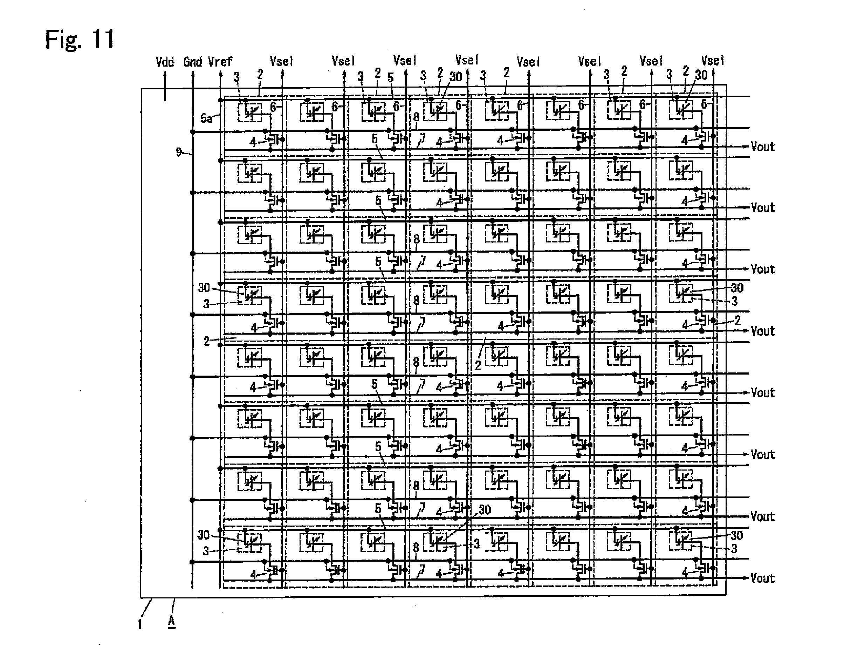

This embodiment discloses the infrared array sensor **A** comprises a plurality of the image elements (shown in Fig. 3) and the base **1.** Each one of the image elements **2** comprises a thermo-type infrared detection member **3** and the MOS transistor **4** which is defined as a switching element for selecting the image element. A plurality of the image elements **2** is arranged on the surface of the base **1** such that the image elements are arrayed. Specifically, a plurality of the image elements **2** are arranged on the surface of the base **1** in two dimensional array. The base **1** is made from the silicon substrate **1a.** In this embodiment, the base **1** is provided at its surface with m × n numbers of the image elements **2.** (In the example of Fig. 3 and Fig. 11, 8 × 8 numbers of the image elements **2** are employed.) However, the image elements **2** are not limited its number and the arrangement. In addition, in this embodiment, the thermo-type infrared detection member **3** comprises the thermosensing portion **30.** the thermosensing portion **30** is realized by a plurality of the thermosensors **30a** which are arranged in series with each other (shown in Fig. 1). (In this embodiment, the six thermosensors **30a** are arranged in series with each other.) Each the thermosensors **30a** is realized by the thermopile. In Fig. 11, the equivalent circuit of the thermosensing portion **30** of the thermo-type infrared detection member **3** is represented by the voltage source Vs corresponding to the thermal electromotive force of the photosensitive portion **30.**

In addition to the above, as shown in Fig. 1, Fig. 4 and Fig. 11, the infrared array sensor **A** in this embodiment comprises a plurality of the perpendicular readout lines **7,** a plurality of the horizontal signal lines **6,** a plurality of the ground line **8,** a common ground line **9,** and a plurality of the reference bias lines **5.** Each one of the perpendicular readout lines **7** is mutually connected to each one end of the thermosensing portions **30** of the thermo-type infrared detection member **3** in each column through the MOS transistor **4.** Each one of the horizontal signal lines **6** is mutually connected to the gate electrode **46** of the MOS transistor **4** corresponding to the thermosensing portion **30** of the thermo-type infrared detection member **3** in each the row. Each one of the ground lines 8 are mutually connected to the p⁺-type well region **41** of the MOS transistor **4** in each one of the rows. Each one of the reference bias lines are mutually connected to the remaining end of the thermosensing portions **30** of the tyermo-type infrared detection members **3** in each the column. This configuration is set to read out the output of the thermosensing portion **30** of the thermo-type infrared detection members **3** in time series. That is to say, the infrared array sensor **A** in this embodiment comprises a plurality of the image elements **2.** The base **1** is provided at it surface with the image elements each of which comprises the thermo-type infrared detection member **3** and the MOS transistor **4.** The MOS transistor **4** is provided for read out the output of the thermo-type infrared detection member **3,** thereby being arranged adjacent to the thermo-type infrared detection member **3.**

The MOS transistor **4** comprises the gate electrode **46,** the source electrode **48,** and the drain electrode **47.** The gate electrode **46** is connected to the horizontal signal line **6.** The source electrode **48** is connected to the reference bias line 5 through the thermosensing portion **30.** Each one of the reference bias lines **5** are mutually connected to each one of the the common reference bias lines **5a.** The drain electrode **47** is connected to the perpendicular readout line **7.** Each one of the horizontal signal lines **6** are electrically connected to each one of the pads **Vsel** for selecting the image elements. Each one of the perpendicular readout lines **7** is electrically connected to each one of the output pad **Vout.** The common ground line **9** is electrically connected to the pad **Gnd** for grounding. The common reference bias line 5a is electrically connected to the pad **Vref** for reference bias. The silicon substrate is electrically connected to the pad **Vdd** for the substrate.

Therefore, the MOS transistor **4** is turned on to have the on state in order according to the control of the voltage of the pad **Vsel** for selecting the image element. Consequently, the image element **2** is read out its output signal defined by the output voltage, in order. For example, when "the pad **Vref** for reference bias is set to 1.65 V", "the pad **Gnd** for grounding is set to 0 V", "the pad **Vdd** for substrate" is set to 5 V", and "the pad **Vsel** for selecting the image element" is set to 5 V, the MOS transistor 4 is turned on. Consequently, the output voltage of the image element is read out from the output pad **Vout.** (The output voltage is a sum of 1.65 V and the output voltage of the thermosensing portion **30.**) When the pad **Vsel** for selecting the image element is set to **0** V, the MOS transsitor **4** is turned off. Consequently, the output voltage of the image element **2** is not read out from the output pad **Vout.** It is noted that Fig. 3 shows "the pad **Vsel** for selecting the image element", "the pad **Vref** for reference bias", "the pad **Gnd** for grounding", and "the output pad **Vout**"are not distinguished from each other, whereby all the pads are symbolized by the reference numeral "**80**".

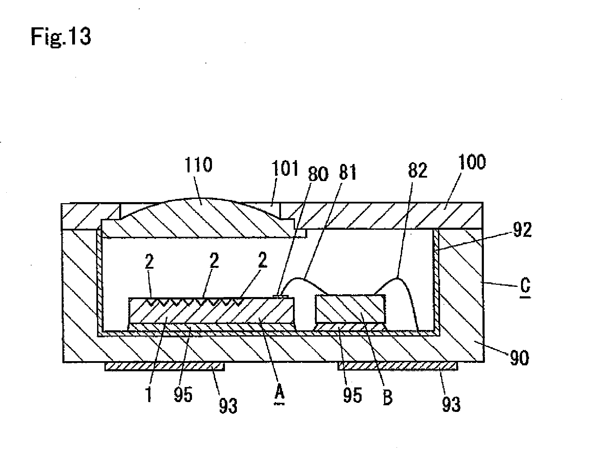

Fig. 13 shows the infrared array sensor module. The infrared array sensor module comprises the infrared array sensor **A,** the IC chip B for signal processing, and the package C. The IC chip B for signal processing is configured to perform the signal processing with respect to the output voltage defined by the output signal of the infrared array sensor **A.** The package C is configured to house the infrared array sensor **A** and the IC chip B for signal processing. In this case, the IC chip B for signal process is provided with a plurality of pads, the amplifying circuit, and the multiplexer. A plurality of the pads of the IC chip B for the signal processing is electrically connected to the pads **80** of the infrared array sensors A, respectively, through the bonding wires **81.** In addition, a part of the pads of the IC chip B for signal processing is connected to the output pad **Vout** of the infrared array sensor **A.** (Hereinafter, a part of the pads of the IC chip B for signal processing is referred to as input pad.) The amplifying circuit is configured to amplify the output voltage which is output from the input pad. The multiplexer is configured to selectively input the output voltages of the input pads to the amplifying circuit. With this configuration, it is possible to obtain the image created on the basis of the infrared.

The package C comprises the package main body **90** and the package cap **100.** The package main body **90** is made from a multilayered ceramic substrate (ceramic package). The multilayered ceramic substrate is shaped to have a rectangular box shape and is provided at its one surface with an opening. The package main body **90** has an inside bottom which is provided for mountiong the infrared array sensor **A** and the IC chip B for signal processing. The package cap **100** is provided with a lens **110** which is configured to focus the infrared to the infrared array sensor **A.** The package cap **100** is realized by the metal lid which is shaped to cover one surface of the package main body **90.** The package main body **90** is cooperative with the package cap **100** to form the air tight space having the dry nitrogen atmosphere. The periphery of the package cap **100** is fixed to the patterned metal having the rectangular frame shape on one surface of the package main body **90** by the seam welding. It is noted that the package main body **90** is not limited to the multilayered ceramic substrate. The package main body **90** may be realized by the multilayered substrate being realized by stacking the glass epoxy resin substrates.

The package main body **90** is provided at its inside surface with a patterned conductor **92** for shielding. The infrared array sensor **A** and the IC chip for signal processing is connected to the patterned conductor **92** for shielding of the package main body **90** through the joining layer **95, 95** made of the joining material having the electrical conductivity (such as solder and the Ag paste). It is noted that the joining method of joining the infrared array sensor **A** and the package main body **90** is not limited to the joining method of using the joining material such as solder and Ag paste. The joining method of joining IC chip B for signal processing and the package main body **90** is not limited to the joining method of using the joining material such as solder and Ag paste. For example, it is possible to employ the normal temperature joining method and the joining method of using the Au-Sn eutectic or Au-Si eutectic as the joining method. However, the joining method of establishing the direct joining such as normal temperature joining method is preferably employed, compared with the joining method of using the joining material having the electrical conductivity. It is possible to easily improve the accuracy of the distance between the infrared array sensor **5** and the lens **110** by using the direct joining method such as normal temperature joining method of directly joining.

The lens **110** is made of material such as Si which is a type of the material having a property of passing the infrared. The lens **110** may be manufactured by means of LIGA process or the manufacturing method of the semiconductor lens with using the anode oxidization method (disclosed in Japanese patent publication No. 3897055B and No. 3897056B). The lens **110** is attached to the periphery of the aperture **101** of the package cap **100** with the adhesive agent having the electrical conductivity, whereby the lens **110** covers the aperture **101.** (The adhesive agent is exemplified by the solder and the Ag paste.) In addition, the lens **110** is electrically connected to the patterned conductor **92** for shielding of the package main body **90.** With this configuration, in the above mentioned infrared array sensor module, it is possible to prevent the decrease of S/N ratio due to the electromagnetic noise from the outside of the module. It is noted that the lens **110** may employ the optical filter for infrared as necessary. (the optical filter for infrared is exemplified by a bandpass filter and the brad spectrum cutoff filter.) The optical filter for infrared is realized by many different types of the thin films which are alternately stacked and which are different in the refractive index.

In addition, in the above mentioned infrared array sensor module, the infrared array sensor **A** comprises the base **1** which is shaped to have a rectangular shape. All the pads **80** of the infrared array sensor **A** is arranged along a side of the rim of the base **1.** The IC chip B for signal processing is shaped to have a rectangular shape. In addition, each the pads **80** of the infrared array sensor **A** is electrically connected to the pads arranged along a side of the outer rim of the IC chip B for signal processing. The infrared array sensor **A** and the IC chip for signal processing **B** are arranged such that a side of the base **1** of the infrared array sensor **A** is located in a near position with respect to one of the sides of the IC chip B for signal processing, compared with the other of the sides of the IC chip B for signal processing. This configuration makes it possible to shorten the wiring 81 for connecting each the pad **80** of the infrared array sensor **A** and the each the pad of the IC chip B for signal processing. Consequently, it is possible to reduce the influence of the noise from the outside. Therefore, it is possible to improve the noise resistance.

Hereinafter, the structures of the thermo-type infrared detection member **3** and the MOS transistor **4** are explained. It is noted that this embodiment employ the silicon substrate **1a** which is realized by the single crystal silicon substrate. The single crystal silicon substrate has a conductivity type of n-type and has a (100) surface.

Each the image elements **2** on the surface of the silicon substrate **1** is provided with a forming region **A1** for forming the thermo-type infrared detection member **3,** whereby the thermo-type infrared detection member **3** is formed on the forming region **A1.** Each the image element **2** on the surface of the silicon substrate **1a** is provided with a forming region **A2** for forming the MOS transistor **4,** whereby the MOS transistor **4** is formed on the forming region **A2.**

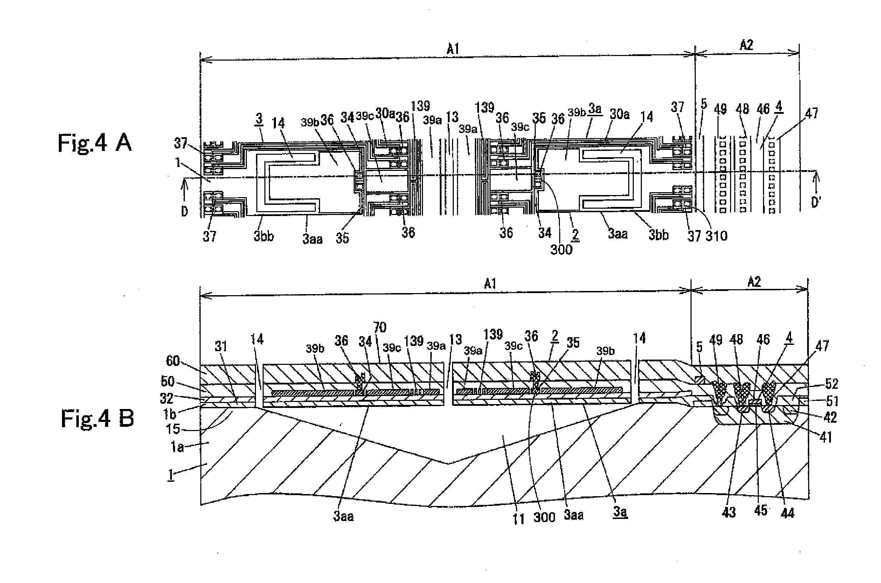

Each the image element **2** is provided with an infrared absorption member **33** which is configured to absorb the infrared. Therefore, the base **1** is provided with a plurality of the recesses **11** in order to establish the heat insulation of the infrared absorption member **33** from the base **1.** Consequently, as shown in Fig. 4 B, the rim **15** surrounds the recess **11.** In addition, the recess has an inner periphery which is defined by the rim. The base **1** is provided at its surface with a thin film structural body **3a.** The thin film structural body **3a** is located in an inside of the recess **11** when seen in the planar view, whereby the thin film structural body **3a** covers the recess **11.** In other words, the thin film structural body **3a** is located in an inside of the rim. In addition, in each the image element **2,** the thin film structural body **3a** is provided with a plurality of the first slits **13** which have line shapes. The first slit **13** penetrates through the thin film structural body **3a** from the rear surface to the front surface. The first slit **13** divides the thin film structural body into a plurality of the sub-thin film structural body **3aa;** the sub-thin film structural bodies **3aa** are arranged in circumferential direction of the recess. The sub-thin film structural bodies **3aa** extend toward an inside direction from the periphery of the recess 11 of the base 1. (According to Fig. 1, the six sub-thin film structural bodies **3aa** are prepared.) (A plurality of the first slits **13** having line shapes divides the thin film structural body into a plurality of the sub-thin film structural bodies **3aa.** The sub-thin film structural bodies **3aa** are arranged along a periphery of the recess **11.** The sub-thin film structural bodies **3aa** are supported at their one ends by the base 1.) The sub-thin film structural bodies **3aa** have lengths and widths, respectively. Each one of the sub-thin film structural bodies **3aa** has one lengthwise end which is defined as the first end and the other lengthwise end which is defined as the second end. The sub thin film structural body **3aa** is fixed at its first end to the rim 15 of the base **1.** Consequently, the sub-thin film structural body **3aa** acts as the cantilever **3aa.** Each one of the sub-thin film structural body (cantilever) **3aa** is provided with the thermosensor **30a.** In addition, the thermosensors **30a** are electrically connected to establish a predetermined connection relationship. Specifically, all the thermosensors **30a** are electrically connected to establish the connection relationship that all the thermosensors **30a** are set to generate the output having the variation. The variation of the output depends on the temperature variation. The variation of the output from all the thermosensors is greater than the variation of the output from each the thermosensor. Specifically, all the thermosensors **30a** are electrically connected such that all the thermosensors **30a** are cooperative with each other to output the sum of the output of each the thermosensor **30a.**
Consequently, when the variation of the temperature in the thermosensors **30** are caused, the first output signal which is output from each the thermosensor **30a** is varied. All the thermosensors **30a** are electrically connected to each other to have a predetermined connection relationship that the variation of the output is increased. Therefore, the variation of the temperature of each the thermosensor **30a** is caused, the thermosensors **30** are cooperative with each other to generate the second output signal. The second output signal is greater than the first output signal. The infrared absorption member **33** is divided into a plurality of portions which correspond to the sub-thin film structural bodies (cantilevers) **3aa,** respectively. The portions which correspond to the sub-thin film structural bodies **3aa,** respectively, are referred to as the infrared absorption members **33a.**

It is noted that there is no need to connect all the thermosensors **30a** of the thin film structural body **3a** in serial. (In the above explained case, there is no need to connect six thermosensors **30a** in series.) For example, it is possible to employ series circuits each of which comprise three thermosensors **30a** which are connected in series, and to connect the series circuits in parallel. With this configuration, it is possible to improve the sensitivity, compared with a case where all six thermosensors **30a** are connected in parallel or compared with a case where the output is extracted from each the thermosensor **30a.** In addition, this configuration makes it possible to decrease the electrical resistance of the thermosensing portion **30,** compared with a case where all the six thermosensors **30a** are connected in series. Therefore, it is possible to reduce the thermal noise. This results in the improvement of the **S/N** ratio.

In the image element **2,** each one of the sub-thin film structural bodies (the cantilevers) **3aa** is provided with two bridges 3bb, 3bb. Consequently, the base 1 and the infrared absorption member **33a** are coupled by the bridges 3bb. The bridges 3bb are arranged in a circumferential direction of the recess **11,** and are spaced from each other. The bridges 3bb are shaped to have rectangular shapes. In addition, each one of the the sub-thin film structural bodies (cantilevers) **3aa** is provided with a second slit **14** which is communicated with the recess **11.** The second slit penetrates through the sub-thin film structural body 3aa from the rear surface to the front surface. In addition, the second slit **14** is communicated with the recess **11.** Therefore, the second slit **14** is overlapped with the recess **11** in the thickness direction of the base **1.** Therefore, the sub-thin film structural body (cantilever **3aa**) comprises the bridges **3bb,** a holding plate, and a sub holding plate. The bridge is fixed at its first end to the rim. The bridge extends toward an inside from the rim. Consequently, the bridge has the second end which is opposite of the first end. The holding plate is held by the second end of the bridge such that the holding plate is overlapped with the recess in a thickness direction of the base. The sub holding plate extends from the holding plate toward the first end of the cantilever. In addition, the sub holding plate is spaced from the bridges. Consequently, the cantilever has the second slit having U-shape. **In** addition to the above, the base **1** has a portion which surrounds the thin film structural bodies **3a** and which has a rectangular frame shape when the base **1** is seen in the planar view. In other words, the base **1** has a portion which surrounds the thin film structural bodies **3a** and which is shaped to have a rectangular shape along a plane perpendicular to the thickness direction of the base **1.** In addition, the bridge **3bb** has a connection portion with respect to the infrared absorption member **33** and a connection portion with respect to the base **1,** and has a portion other than the connection portions. The portion other than the connection portions of the bridge **3bb** is spaced from "the infrared absorption member **33a** and the base 1" by "the first slits **13,** the second slits **14".** That is to say, the sub-thin film structural body (cantilever) **3aa** has a length of 93 micrometers in a direction extending from the base **1,** has a width of 75 micrometers in a direction perpendicular to the direction extending from the base **1.** Each the bridges **3bb** has a width of 23 micrometers. Each the first slit **13** and the second slit **14** has a width of 5 micrometers. However, the values of the above are only one example, whereby the values are not limited thereto.

The thin film structural body **3a** mentioned in the above comprises the multilayered member. The multilayered member comprises the silicone dioxide film **1b,** the silicon nitride film **32,** the thermosensing portion **30,** the insulation film **50,** and the passivation film **60.** The multilayered member is patterned. The silicon dioxide film **1b** is formed on the surface of the silicon substrate **1a.** The silicon nitride film **32** is formed on the silicon dioxide film **1b.** The thermosensing potion **30** is formed on the silicon nitride film **32.** The insulation film **50** is realized by the BPSG film which is formed to cover the surface of the silicon nitride film **32.** The passivation film **60** is realized by the PSG film and the NSG film; the PSG film is formed on the insulation film **50;** the NSG film is formed on the PSG film.

In this embodiment, the silicon nitride film **32** has a certain portion other than the bridges **3bb, 3bb** of the thin film structural body **3a,** and the certain portion is defined as the infrared absorption member **33.** In addition, the silicon substrate **1a** is cooperative with the silicon nitride film **32,** the insulation film **50,** and the passivation film to construct the base **1.** In addition, in this embodiment, the stacked film of the insulation film **50** and the passivation film **60** extends from "the forming region **A1** for forming the thermo-type infrared detection member **3"** to "the forming region A2 for forming the MOS transistor 4". In addition, the thermo-type infrared detection member 3 has a portion which is located on the forming region **A1.** The portion of the thermo-type infrared detection member 3 which is located on the forming region **A1** also acts as the infrared absorption film 70 (shown in Fig. 4 B). In addition to the above, when "the infrared absorption film **70** has the refractive index of **n₂**" and "the infrared to be detected has a center wavelength of **λ"**, the infrared absorption film **70** has a thickness **t2** which satisfies the formula of **"λ/4n₂** ". This configuration makes it possible to improve the efficiency of the absorption of the infrared having the wavelength (such as 8 to 12 micrometers) to be detected. Therefore, it is possible to achieve the high sensitivity For example, when "**n**₂ is equal to 1.4" and **"λ** is equal to 10 micrometers", **t2** is set to have about 1.8 micrometers. It is noted that this embodiment comprises the insulation film **50** having a thickness of 0.8 micrometers and the passivation film **60** having a thickness of 1 micrometers. (PSG film has a thickness of 0.5 micrometers and NSG film has a thickness of 0.5 micrometers.) In addition, the infrared absorption film **70** is not limited to the above configuration, whereby the infrared absorption film **70** may be realized by the silicon nitride film.

In addition, the image element **2** comprises the thermosensors **30a** which are realized by the thermopiles, respectively. Furthermore, the thermosensors **30a** are arranged to have a connection relationship of establishing the series connection. In addition, each the image element **2** has the recess **11** with an inner periphery which has a rectangular shape.

The thermosensor **30a** realized by the thermopile comprises a plurality of the thermoelectric couples. Each the thermoelectric couple (in the example of Fig. 1, the number of the thermoelectric couples is nine) comprises n-type polysilicon layer **34,** p-typo polysilicon layer **35,** and a connection member **36** which electrically connects one end of the n-type polysilicon layer **35** and one end of the p-type polysilicon layer **36** at an entrance surface of the infrared; the connection member **36** is made of metal material (such as Al-Si). The n-type polysilicon layer **34** and the p-type polysilicon layer **35** are formed on the silicon nitride film **32,** and extends from the sub-thin film structural body (cantilever) **3aa** to the base **1.** That is, the thermoelectric couples are disposed on the cantilever such that the thermoelectric couples extend through the bridges. In addition to the above configuration, the thermosensor **30a** which is constructed by the thermopile comprises "the hot junction **300** which is located on the side of the infrared absorption member **33a"** and "the cold junction located on the side of the base **1";** the hot junction **300** is defined by "the one end of the n-type polysilicon layer **34,** the one end of the p-type polysilicon layer **35,** and the connection member **36";** the cold junction **310** is defined by "the remaining end of the n-type polysilicon layer **34,** the remaining end of the p-type polysilicon layer **35,** and the connection member **37".** The thermopile is configured to output a predetermined output signal when the temperature difference is caused between the hot junction and the cold junction. That is to say, when the temperature difference between the hot junction and the cold junction is caused, the thermopile generates the output signal according to the variation of the temperature.

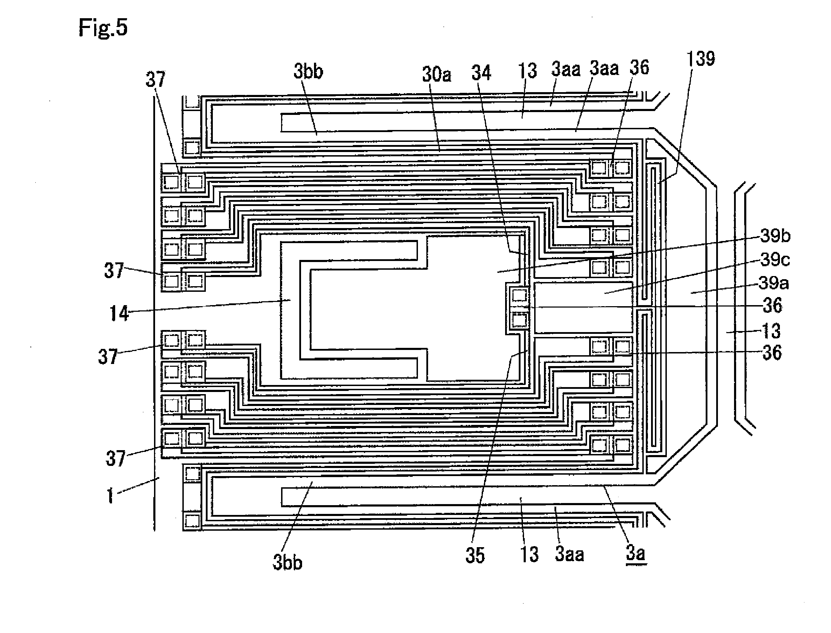

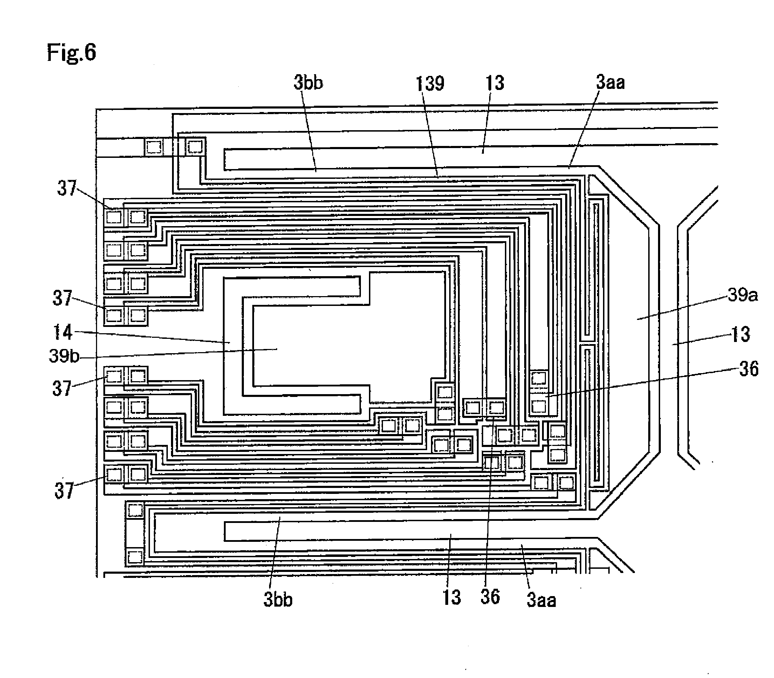

In addition, the infrared array sensor **A** in this embodiment has a recess **11** having a shape of four-sided pyramid. Furthermore, in the planar view, the depth of the center of the recess is greater than the depth of the peripheral portion of the recess. In other words, the recess **11** has an opening which is perpendicular to the thickness of the base 1. The opening has an opening size. The opening size gradually becomes smaller toward the rear surface of base **1** from the front surface of the base **1.** The thermosensors **30a** of the image element **2** has a planar layout such that the hot junctions are located in a center portion of the thin film structural body **3a.** That is, in the sub-thin film structural bodies **3aa** at a center position in the upper-lower direction of Fig. **1****,** as will be understood from Fig. 1 and Fig. 5, the connection members **36** are arranged in a direction of arranging the three sub-thin film structural bodies (cantilevers) **3aa.** In contrast, in the two sub-thin film structural bodies **3aa** in the upper side of the upper-lower direction, as will be understood from Fig. 1 and Fig. 6, the connection members **36** are intensively arranged to the portion close to the sub-thin film structural bodies (cantilevers) **3aa** at the center portion in the direction of arranging the sub-thin film structural bodies (cantilevers) **3aa..** In the two sub-thin film structural bodies **3aa** in the lower side of the upper-lower direction, as will be understood from Fig. 1, the connection members **36** are intensively arranged to the portion closer to the sub-thin film structural bodies (cantilevers)**3aa** at the center portion in the direction of arranging the sub-thin film structural bodies (cantilevers) **3aa**. Consequently, in the infrared array sensor **A** of this embodiment, "the arrangement of the connection members 36 of the sub-thin film structural bodies (cantilevers) **3aa** at the upper side in the upper-lower direction of Fig. 1" makes it possible to increase the temperature variation of the hot junction, compared with a case where "the arrangement of the connection members 36 of the sub-thin film structural bodies (cantilevers) **3aa** at the upper side in the upper-lower direction of Fig. 1 is equivalent to the arrangement of the connection member **36** of the sub-thin film structural bodies (cantilevers)**3aa** at the center portion in the upper-lower direction of Fig. 1". In the infrared array sensor **A** of this embodiment, "the arrangement of the connection members **36** of the sub-thin film structural bodies (cantilevers) **3aa** at the lower side in the upper-lower direction of Fig. 1" makes it possible to increase the temperature variation of the hot junction, compared with a case where "the arrangement of the connection members 36 of the sub-thin film structural bodies (cantilevers) **3aa** at the lower side in the upper-lower direction of Fig. 1 is equivalent to the arrangement of the connection member **36** of the sub-thin film structural bodies (cantilevers)**3aa** at the center portion in the upper-lower direction of Fig. 1". Therefore, this configuration makes it possible to improve the sensitivity.

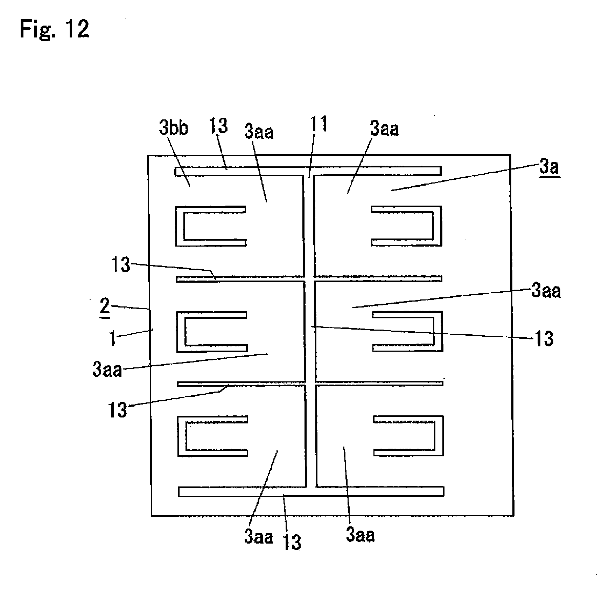

In addition, the sub-thin film structural body (cantilever) **3aa** has a certain region which comprises no thermosensor **30a** in the incidence plane, for the infrared, of the silicon nitride film **32.** The sub-thin film structural body (cantilever) **3aa** is provided at its certain region with an infrared absorption layer **39.** (The infrared absorption layer **39a** comprises the first infrared absorption layer **39a,** the second infrared absorption layer **39b,** and the third infrared absorption layer **39c,** shown in Fig. 1, Fig. 4, and Fig. 8.) The infrared absorption layer **39 (39a, 39b,** and **39c)** is made of n-type polysilicon layer. The n-type poly silicon layer prevents the warpage of the sub-thin film structural body (cantilever) **3aa** and absorbs the infrared. Specifically, the first infrared absorption layer **39a** is disposed on the second end in the lengthwise direction of the thin film structural body **3aa**, whereby the first infrared absorption layer **39** is opposite of the first end. (However, there is only need for the first infrared absorption layer **39a** to be located between the second slit **14** and the second end.) Therefore, the hot junction **300** is located between the second end and the second slit. Furthermore, the hot junction **300** is located between the first infrared absorption layer **39a** and the second slit **14.** In addition, the second infrared absorption layer 39b is arranged between the second slit **14** and the second end, whereby the second infrared absorption layer **39b** is spaced from the first infrared absorption layer **39a.** Therefore, the second infrared absorption layer **39b** is located between the hot junction **300** and the second slit **14**. In other words, the second infrared absorption layer is held by the sub holding plate, whereby the second infrared absorption layer is located between the second slit **14** and the second end. In addition, the hot junction **300** is located between the second infrared absorption layer 39b and the first infrared absorption layer **39a**. In addition, the third infrared absorption layer 39c is provided to the sub-thin film structural bodies (cantilevers) **3aa** at a center portion among the six sub-thin film structural bodies (cantilevers). The third infrared absorption layer 39c is located between the first infrared absorption layer **39a** and the second infrared absorption layer **39b**. In addition, in the infrared array sensor **A** in this embodiment, a tip of the sub-thin film structural body (cantilever) **3aa** in the extending direction of the sub-thin film structural body is chamfered. In addition, the both side of the tip of the sub-thin film structural body (cantilever) **3aa** in the extending direction of the sub-thin film structural body is chamfered. Therefore, it is possible to reduce the breakage caused in the manufacturing, compared with a case where the chamfer is not made as shown in Fig. 12. Furthermore, it is possible to easily form the recess **11,** whereby it is possible to improve the fabrication yield. In addition, in the above explanation, the chamfering is made. However, the chamfering is not limited to the above. Therefore, it is possible to make a round chamfering.

In addition, the infrared array sensor **A** in this embodiment comprises the wiring **139** for fault diagnosis. The wiring **139** for fault diagnosis is provided to each the image elements. The wiring **139** for fault diagnosis extends from the base **1** through one of the bridges **3bb,** the infrared absorption member **33a,** and the other of the bridges **3bb,** to the base **1.** In addition, the wirings **139** for fault diagnosis are connected in series. Consequently, according to the energization of the series circuit of the wirings **139** for fault detection having m×n number, it is possible to detect the existence or nonexistence of the breakage (such as break off) of the bridge **3bb.**

The infrared absorption layer **39a, 39b,** and **39c** and the wiring **139** for fault diagnosis and the n-type polysilicon layer **34** comprises the same n-type impurity (such as phosphorus) at the same impurity concentration (such as 10¹⁸ to 10²⁰ cm⁻³). Therefore, the infrared absorption layers **39a, 39b,** and **39c,** the wiring **139** for fault diagnosis, and the n-type polysilicon layer **34** are formed simultaneously. It is noted that the p-type polysilicon layer **35** may include the p-type impurity such as boron. In this case, the concentration of the impurity may be set to have a range, arbitrarily, such as 10¹⁸cm⁻³ to 10²⁰cm⁻³. In this embodiment, each the n-type polysilicon layer **34** and the p-type polysilicon layer **35** has the impurity concentration of 10¹⁸ cm⁻³ to 10²⁰ cm⁻³. Consequently, it is possible to reduce the resistance value of the thermoelectric couple. Therefore, it is possible to improve the S/N ratio. In addition, the infrared absorption layer **39a, 39b** and **39c**, the wiring **139** for fault diagnosis, and the n-type polysilicon layer **34** are prepared with doping the same n-type impurity at the same impurity concentration. However, the configuration is not limited thereto, whereby it is possible to employ the infrared absorption layer **39a, 39b** and **39c** and the wiring **139** for fault diagnosis with doping the impurity same as the impurity of the p-type polysilicon layer **35**.

By the way, if "the n-type polysilicon layer **34**, p-type polysilicon layer **35**, infrared absorption layer **39a, 39b,** and **39c,** and the wiring **139** for fault diagnosis are set to have the refractive index of **n**₁ " and "the center wavelength of the infrared to be detected is assumed as λ", the n-type polysilicon layer **34,** each one of the p-type polysilicon layer **35,** the infrared absorption layer **39a, 39b,** and **39c,** and the wiring **139** for fault diagnosis are set to have a thickness **t1** which is equal to λ**/4n₁.** Therefore, the absorption efficiency of the infrared having the wavelength ( such as 8 micrometers to 12 micrometers) to be detected is improved. Therefore, it is possible to improve the sensitivity. For example, if "**n**₁ is equal to 3.6" and "**λ** is equal to 10 micrometers", "**t1** is approximately equal to 0.69 micrometers".

In addition, in this embodiment, the n-type polysilicon layer **34,** the p-type polysilicon layer **35,** the infrared absorption layer **39a, 39b,** and **39c,** and the wiring **139** for fault diagnosis have the impurity at impurity concentration of 10¹⁸ cm⁻³ to 10²⁰cm⁻³. Therefore, it is possible to improve the absorption ratio of the infrared, and to prevent the reflection of the infrared. This results in the improvement of the S/N ratio of the output of the thermosensing portion **30.** In addition, this configuration makes it possible to form the infrared absorption layer **39a, 39b,** and **39c,** the wiring **139** for fault diagnosis, and the n-type polysilicon layer **34** by the same manufacturing process. Therefore, this configuration makes it possible to manufacture them at low cost.

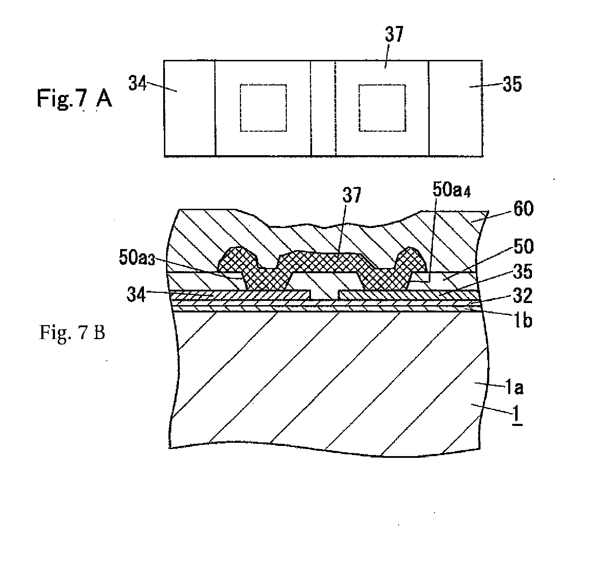

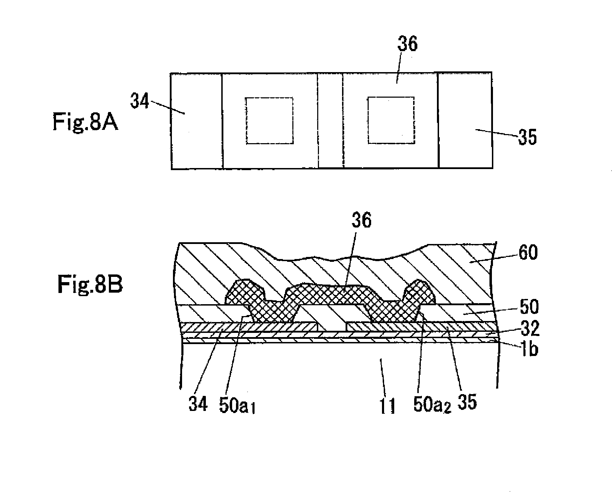

In addition to the above, the connection member **36** of the thermosensing portion **30** is electrically insulated from the connection member **37** of the thermosensing portion **30** by the insulation film **50** on the surface of the base **1**. (This is shown in Fig. 7 and Fig. 8.) That is, "the connection member **36** on the same side as the hot junction" is electrically connected to one end of the polysilicon layer **34** through the contact hole **50a1** of the insulation film **50,** and also is electrically connected to one end of the polysilicon layer 35 through the contact hole **50a2** of the insulation film **50.** "The connection member 37 on the same side as the cold junction" is electrically connected to a remaining end of the polysilicon layer **34** through the contact hole **50a3** of the insulation film **50,** and also is electrically connected to a remaining end of the polysilicon layer **35** through the contact hole **50a4** of the insulation film **50.**

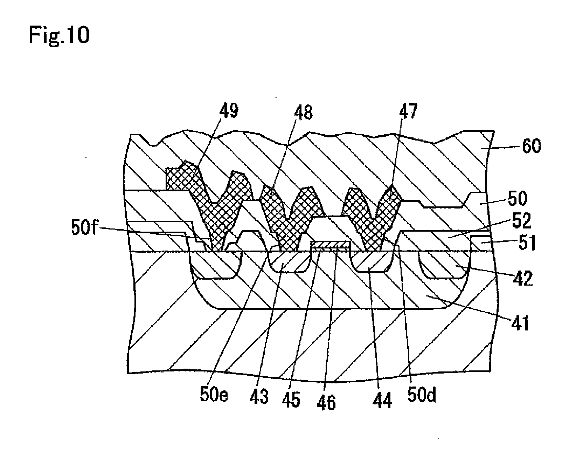

In addition, the MOS transistor **4** is formed on the forming region **A2** of the MOS transistor in each the image element on the surface of the silicon substrate **1a**. The MOS transistor **4** is, as shown in Fig. 4 and Fig. 10, provided at the surface of the silicon substrate **1a** with p⁺-type well region **41.** The p⁺-type well region **41** is provided with n⁺-type drain region **43** and n⁺-type source region **44** which is spaced from n⁺-type drain region **43.** In addition, p⁺-type well region **41** is provided with p⁺⁺-type channel stopper region which surrounds the n⁺-type drain region **43** and n⁺-type source region **44.** In addition, the p⁺-type well region **41** has a certain portion which is located between the n⁺-type drain region **43** and the n⁺-type source region **44,** and is provided at the certain portion with the gate electrode **46** through the gate insulation film **45.** The gate electrode **46** is made of n-type polysilicon layer. Furthermore, the drain electrode **47** is formed on the n⁺-type drain region **43.** (The drain electrode **47** is made metal material such as Al-Si.) In addition, the source electrode **48** is formed on the n⁺-type source region **44.** (The source electrode **48** is made of metal material such as Al-Si.) The gate electrode **46,** the drain electrode **47,** and the source electrode **48** are electrically insulated from each other by the insulation film **50.** That is, the drain electrode **47** is electrically connected to the n⁺-type drain region **43** through the contact hole **50d** of the insulation film **50.** The source electrode **48** is electrically connected to the n⁺-type source region **44** through the contact hole **50e** of the insulation film **50.**

In each one of the image elements **2** of the infrared array sensor **A** of this embodiment, the source electrode **48** of the MOS transistor **4** is electrically connected to one end of the thermosensing portion **30.** The remaining end of the thermosensing portion **30** is electrically connected to the reference bias line **5.** In each one of the image elements **2** of the infrared array sensor **A** of this embodiment, the drain electrode **47** of the MOS transistor **4** is electrically connected to the perpendicular readout line **7.** The gate electrode **46** is electrically connected to the horizontal signal line **6** which is comprised of the n-type polysilicon wiring which is integrally formed with the gate electrode **46.** In addition, each one of the image elements **2** is provided at its p⁺⁺-type channel stopper **region 42** of the MOS transistor **4** with the electrode **49** for grounding. (The electrode **49** for grounding is made of metal material such as Al- Si.) The electrode for grounding **49** is electrically connected to the common ground line **8.** Consequently, the p⁺⁺-type channel stopper region **42** is electrically biased to have an electrical potential lower than the electrical potentials of the n⁺-type drain region **43** and the N⁺-type source region **44.** Therefore, the elements are separated. It is noted that the electrode **49** for grounding is electrically connected to p⁺⁺-type channel stopper region **42** through the contact hole **50f** of the insulation film **50.**

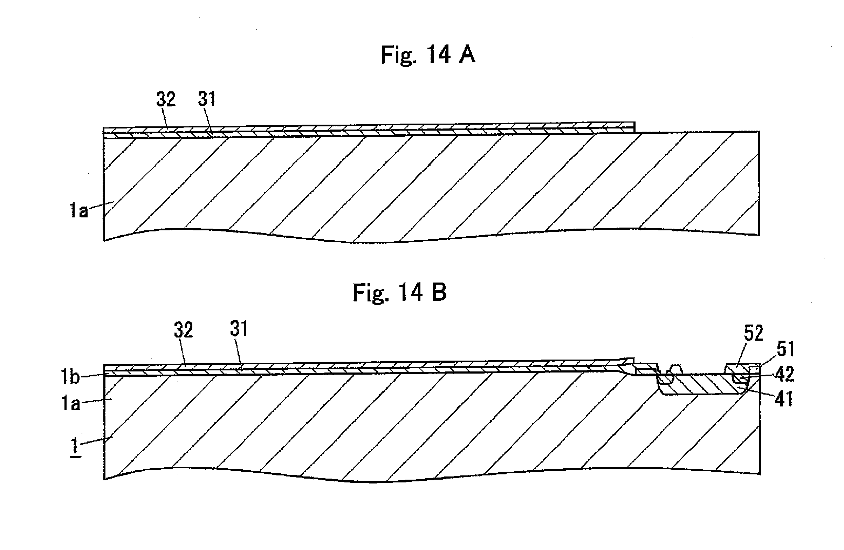

Hereinafter, the explanation of the method of manufacturing the infrared array sensor **A** in this embodiment is made with Fig. 14 to Fig. 17.

Firstly, the insulation layer forming step of forming the insulation layer is performed; the first silicon dioxide film **31** having a first predetermined thickness (for example, 0.3 micrometers) and the silicon nitride film **32** having a second predetermined thickness (for example, 0.1 micrometers) are provided on the surface of the silicon substrate **1a,** whereby the insulation layer which is realized by the layered film is provided on the surface of the silicon substrate **1a.** Subsequent to the above, the insulation layer patterning step is performed with using the photolithography technique and the etching technique. According to the insulation layer patterning step, the portion corresponding to the forming region **A2** for the MOS transistor 4 is etched from the insulation layer, whereby a part of the forming region **A1** for the thermo-type infrared detection member 3 was left. Consequently, the structure shown in Fig. 14 A is prepared. The silicon dioxide film 31 is formed by thermally oxidizing the silicon substrate **1a** at a predetermined temperature (such as 1100 degree C). The silicon nitride film **32** is formed by mean of the LPCVD method.

Subsequent to the above mentioned insulation layer patterning step, the well region forming step is performed, whereby the p⁺-type well region **41** is formed on the surface of the silicon substrate **1a.** Then, the channel stopper region forming step is performed, whereby the p⁺⁺-type channel stopper region 42 is prepared within the p⁺-type well region **41** on the surface of the silicon substrate **1.** Consequently, the structure shown in Fig. 14 B is prepared. The well region forming step comprises following first step, second step, and third step. In the first step, the step of forming the second silicon dioxide film (thermally oxidized film) **51** is selectively formed by thermally oxidizing an exposed portion of the surface of the silicon substrate **1a** at a predetermined temperature is performed. After the first step, the second step of patterning the silicon dioxide film 51 by means of the photolithography technique and the etching technique with using the mask for forming the p⁺-type well region **41** is performed. Subsequent to the second step, the third step of injecting the ion of the p-type impurity (such as boron) is performed, and then drive-step is performed. In this manner, the P⁺-type well region **41** is formed. In addition, the channel stopper region forming step comprises a first step, a second step, and a third step. In the first step, a step of thermally oxidizing the surface of the silicon substrate **1a** at a predetermined temperature to form the third silicon dioxide film (thermally oxidized film), selectively is performed. Subsequent to the first step, the second step of patterning the third silicon dioxide film **52** by means of photolithography technique and etching technique with the mask for forming the p⁺⁺-type channel stoppter region **42** is performed. Subsequent to the second step, the third step of injecting the ion of p-type impurity (such as boron) is performed, and then drive in is performed. In this manner, the p⁺⁺-type channel stopper region **42** is formed. The first silicon dioxide film **31,** the second silicon dioxide film **51,** and the third silicon dioxide film **52** are defined as the silicon dioxide film 1 **b** on the surface.

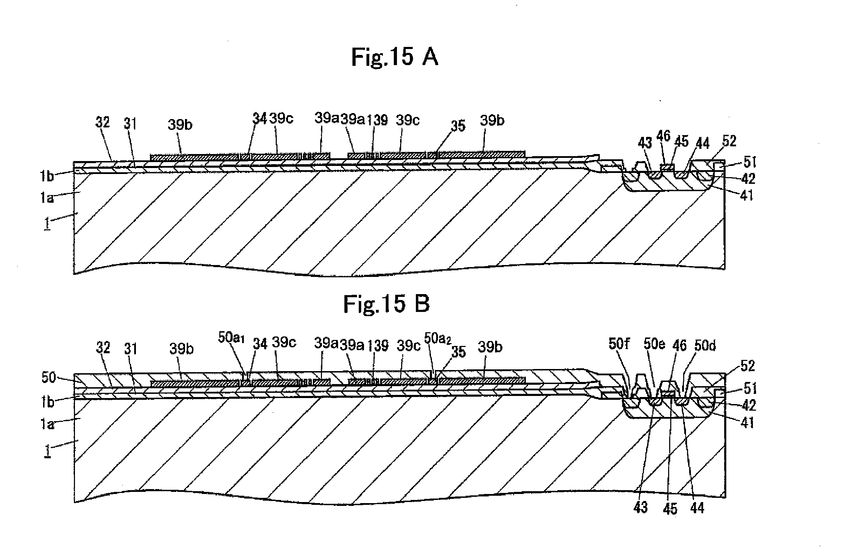

Subsequent to the channel stopper region forming step, the source and drain forming step is performed. In the source and drain forming step, a first step and a second step hereinafter mentioned are performed. That is, in the first step, the step of injecting the ion of n-type impurity (such as phosphorus) to a forming region of the p⁺-type well region is performed; the forming region is defined as a region where the n⁺-type drain region and n⁺-type source region **44** are to be formed. Then, in the second step, a step of driving is performed. Consequently, the source and drain forming step of forming the n⁺-type drain region **43** and n⁺-type source region **44** is performed. Subsequent to the source and drain forming step, the gate insulation film forming step of thermally oxidizing the surface of the silicon substrate **1a** to form a gate insulation film **45** realized by the silicon dioxide film (thermally oxidized film) having a predetermined thickness (for example, 600 angstroms) on the surface of the silicon substrate **1a** is performed. Then, the polysilicon layer forming step is performed to form non-doped polysilicon layer having a predetermined thickness (for example, 0.69 micrometers) on an entire surface of the silicon substrate **1a** by means of the LPCVD method; the non-doped polysilicon layer is a member to be formed into the gate electrode **46,** the horizontal signal line **6** (shown in Fig. 1), the n-type polysilicon layer **34,** p-type polysilicon layer **35,** the infrared absorption layers **39a, 39b,** and **39c,** and wiring **139** for fault diagnosis. Then, the polysilicon layer patterning step is performed to provide a pattern to the non-doped polysilicon layer by means of the photolithography technique and the etching technique, whereby the non-doped polysilicon layer is processed to leave a portion corresponding to the gate electrode **46,** the horizontal signal line **6,** n-type polysilicon layer **34,** p-type polysilicon layer **35,** and the infrared absorption layers **39a, 39b,** and **39c,** and the wiring **139** for fault diagnosis. Then, the polysilicon layer forming step is performed to inject the ion of the p-type impurity (such as boron) into "a portion corresponding to the p-type polysilicon layer **35"** of the non-doped polysilicon layer, and to drive to form the p-type polysilicon layer **35.** Then, the n-type polysilicon layer forming step is performed to inject the n-type impurity (such as phosphorus) to "a portion of the non-doped polysilicon layer" corresponding to the n-type polysilicon layer **34,** the infrared absorption layers **39a, 39b,** and **39c,** the wiring **139** for fault diagnosis **139,** the gate electrode **46,** and the horizontal signal line **6,** and then to drive to form the n-type polysilicon layer **34,** the infrared absorption layer **39a, 39b**, and **39c,** the wiring **139** for fault diagnosis **139,** the gate electrode **46,** and the horizontal signal line **6**. Consequently, the structure shown in Fig. 15 A is prepared. It is noted that the p-type polysilicon layer forming step and the n-type polysilicon layer forming step may be performed in a reverse order.

Subsequent to the p-type polysilicon layer forming step and the n-type polysilicon layer forming step, the insulation film forming step of forming the insulation film **50** on the surface of the silicon substrate **1a** is performed. Then, the contact hole forming step of forming the contact holes **50a1, 50a2, 50a3, 50a4, 50d, 50e,** and **50f** (shown in Fig. 7, Fig. 8, and Fig. 10) to the insulation film **50** by means of the photolithography technique and the etching technique. Consequently, the structure shown in Fig. 15 B is prepared. In the insulation film forming step, the BPSG film having a predetermined thickness (for example, 0.8 micrometers) on the surface of the silicon substrate **1a** is formed on the surface of the silicon substrate **1a** by means of the CVD method, and the BPSG film is flatted at a predetermined temperature (for example, 800 degree C) to prepare the insulation film **50.**

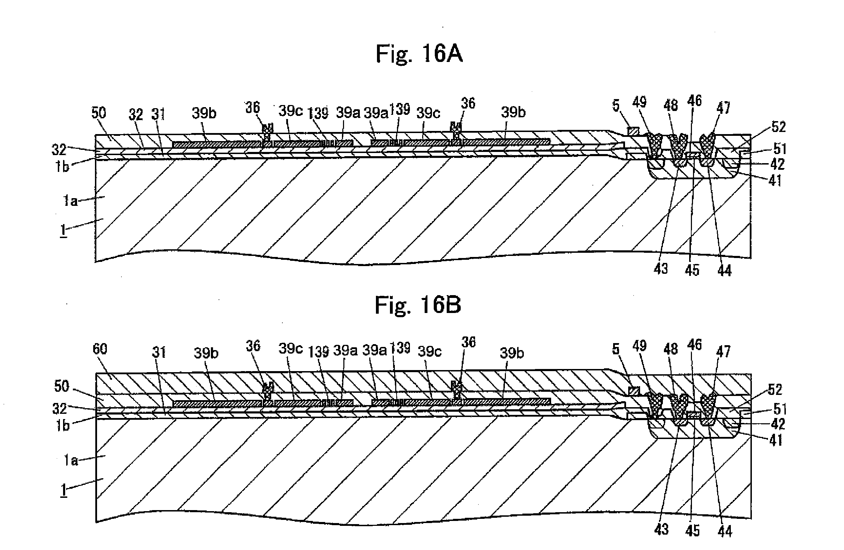

Subsequent to the contact hole forming step, the metal film forming step is performed to form a metal film (such as Al-Si film) having a predetermined thickness (for example **2** micrometers) on an entire of the surface of the silicon substrate **1a;** the metal film is a member to be formed into the connection members **36** and **37,** the drain electrode **47,** the source electrode **48,** the reference bias line **5,** the perpendicular readout line **7,** the ground line **8,** the common ground line **9,** and pads **Vout, Vsel, Vref, Vdd, Gnd.** Then, the metal film patterning step is performed to make a patterning to the metal film with using the photolithography technique and the etching technique, whereby the connection members **36** and **37,** the drain electrode **47,** the source electrode **48,** the reference bias line 5, the perpendicular readout line **7,** the ground line **8,** the common ground line **9,** and the pads **Vout, Vsel, Vref, Vdd, Gnd.** Consequently, the structure shown in Fig. 16 A is prepared. In addition, the etching in the metal film patterning step is performed by RIE.

Subsequent to the metal film patterning step, the passivation film forming step is performed to form the passivation film **60** on the surface (that is, on the surface of the insulation film **50)** of silicon substrate **1a** by the CVD method; the passivation film 6 is realized by a stacked film which comprises the PSG film having a predetermined thickness (for example, 0.5 micrometers) and the NSG film having a predetermined thickness (for example, 0.5 micrometers). Consequently, the structure shown in Fig. 16 B is prepared. It is noted that the passivation film **60** is not limited to the stacked film comprising the PSG film and the NSG film. The passivation film **60** may be realized by the silicon nitride film.

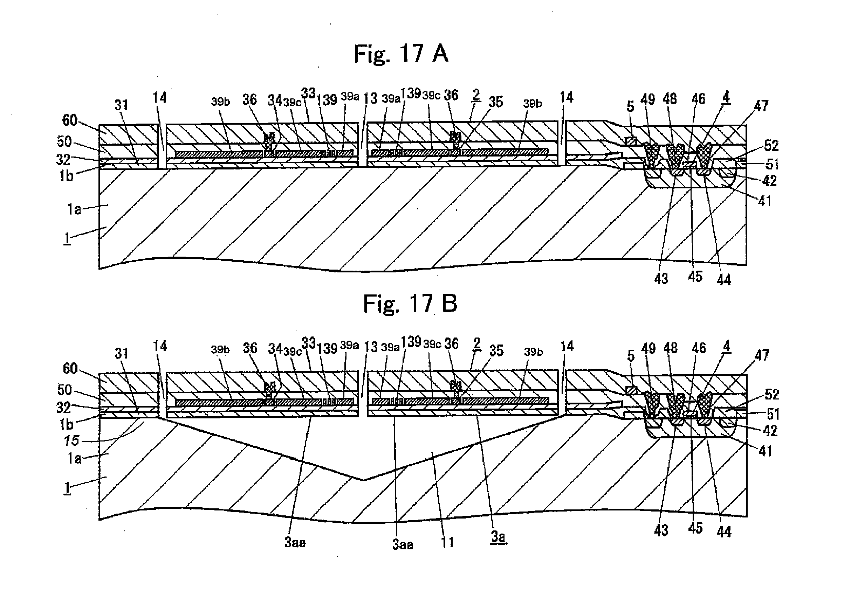

Subsequent to the passivation film forming step, the multilayered member patterning step is performed to make a patterning to the multilayered member which comprises "the heat insulation layer realized by the stacked film of the silicon dioxide film **31** and the silicon nitride film **32",** "the thermosensing portion **30** formed on the heat insulation layer", "the insulation film **50** on the surface of the heat insulation layer to cover the sthermosensing portion **30"** and "passivation film **60** on the insulation film **50",** whereby the sub-thin film structural bodies (cantilevers) **3aa** are formed. Consequently, the structure shown in Fig. 17 A is provided. In addition, each the first slit **13** and the second slit **14** are formed in the multilayered member patterning step.

Subsequent to the multilayered member patterning step, an opening forming step is performed to form the opening (not shown) for the pad by the photolithography technique and the etching technique; the opening for the pad is provided for exposing each the pad **Vout, Vsel, Vref, Vdd,** and **Gnd.** Subsequent to the above, a recess forming step is performed; the recess forming step is a step of "putting the etchant into the first slits **13** and the second slit **14** which are defined as the etchant putting hole" in order to form the recess **11** to the silicon substrate **1a.** Consequently, the infrared array sensor **A** which has the image elements **2** having the structure shown in Fig. 17 B and which are arranged to have two dimensional array. In the above step, the etching in the opening forming step of forming the opening for the pad is performed by RIE. In addition, recess forming step is performed with using the etchant realized by the TMAH liquid solution at a predetermined temperature (for example, 85 degree Celsius). However, the etchant is not limited to the TMAH liquid solution. The alkali solution (such as KOH solution) may be used as the etchant. In addition, all the steps (through the recess forming step) is performed at wafer level. Therefore, there is only need to perform the separating step of separating the infrared array sensors A from each other after the recess forming step. In addition, as will be understood from the above explanation, the well known method of manufacturing the MOS transistor is employed. That is, the basic steps of "forming the thermally oxidized film by the thermal oxidization", "making a pattern of the thermally oxidized film by the photolithography technique and the etching technique", "injecting the ion of the impurity", and "making a drive in (in other words, diffusing the impurity)" are repeated. Consequently, P⁺-type well region **41,** p⁺⁺-type channel stopper region **42,** n⁺-type drain region **43,** and n⁺-type source region **44** are formed.

As explained in the above, this embodiment discloses the infrared array sensor **A** which comprises the base and a plurality of the image elements. The base has a surface. The base is provided at its surface with a plurality of the recesses and a plurality of the rims which surrounds the recess. The recess has an inner periphery which is defined by the rim. The image elements are disposed on the surface of the base such that the image element covers the recess. The image element comprises the thin film structural body, a plurality of the first infrared absorption members, and a plurality of the thermosensors. The thin film structural body is provided with a slit. The slit penetrates through the thin film structural body from the rear surface of the thin film structural body to the front surface of the thin film structural body. Consequently, the slit divides the thin film structural body into a plurality of the cantilevers. The cantilevers are arranged long a rim. The cantilever has a length and a width. The cantilever has one lengthwise end which is defined as the first end, and remaining lengthwise end which is defined as the second end. The first end is fixed to the rim. Each the first infrared absorption member is held by each the cantilever such that the first infrared absorption member is located in an inside of the inner periphery. The thermosensor is disposed on the cantilever. When the temperature of the thermosensor is varied, the thermosensor is configured to generate the output signal corresponding to the temperature variation of the thermosensor. Therefore, the heat in the first infrared absorption member on the cantilever is transferred to the thermosensor, steadily. When the heat generated in the first infrared absorption member which absorbs the infrared is varied, the temperature of the thermosensor is varied. Therefore, this configuration makes it possible for the thermosensor to steadily detect the temperature variation. In addition, it is possible to prevent the deformation of each the sub-thin film structural body **30aa** caused by the stress or the heat stress from the base **1** or outside. Therefore, this configuration makes it possible to improve the structural stability of the thermosensor.

In addition, all the thermosensors are electrically connected to each other to establish a predetermined connection relationship. According to the predetermined connection relationship, all the thermosensors are set to generate an output having a value which is greater than a value of an output which is generated from each the thermosensor. Therefore, this configuration makes it possible to improve the response speed and the sensitivity.

In addition, all the thermosensors are electrically connected to each other to have the predetermined connection relationship. Consequently, when the thermosensors is varied its temperature, the thermosensors cooperates with each other to generate the second output signal. The second output signal is greater than the output signal which is individually output from each the thermosensor. Therefore, it is possible to improve the response speed and the sensitivity.

Furthermore, the thermosensor is realized by the thermopile. Therefore, there is no need to apply the electrical current to each the thermosensor **30a.** Therefore, the thermopile is not self-heated. Therefore, it is possible to prevent the warpage of each the sub-thin film structural body (cantilever) **3aa** caused by the self-heating, compared with a case where the thermosensors **30a** are realized by the resistance bolometer. In addition, it is possible to improve an amount of the consumption of the electrical power. In addition, it is possible to obtain a constant sensitivity, regardless of the temperature, whereby it is possible to obtain the high accuracy. If each the thermosensor **30a** is realized by the thermopile and are connected in series, the thermosensors **30a** outputs the sum of the thermo electromotive forces generated in the thermosensors **30a.** Therefore, it is possible to achieve the connection relationship mentioned in the above, whereby it is possible to improve the sensitivity. It is noted that the thermosensor **30** may be realized by the thermo type infrared detection element. The thermosensor is not limited to the thermopile and the resistance bolometer, whereby the thermosensor may be realized by the pyroelectric element. When the thermosensor **30a** is realized by the pyroelectric element, a plurality of the pyroelectric elements are preferably connected in parallel with each other. Consequently, the pyroelectric elements output the sum of the electrical charge generated by the pyroelectric effect. Therefore, it is possible to satisfy the connection relationship which is explained in the above. Therefore, it is possible to improve the sensitivity.

In addition, the recess is shaped to have a four-sided pyramid shape. Therefore, if the base 1 is made from the silicon substrate, it is possible to easily form the recess by anisotropic etching with using the alkali solution.

Furthermore, the sub-thin film structural body (cantilever) **3aa** is provided with a second slit which is located between the first end and the second end. The second slit penetrates through the cantilever from the rear surface of the cantilever to the front surface of the cantilever. The second slit is formed such that the second slit is overlapped with the recess in the thickness direction of the base. The first infrared absorption member is located between the second slit and the second end. The thermopile has a thermoelectric couple, a hot junction located in one end of the thermoelectric couple, and a cold junction located in remaining one end of the thermoelectric couple. The hot junction is located between the second end and the second slit. The cold junction is located between the first end and the second slit. Therefore, it is possible to improve the response speed and the sensitivity.

In addition, the hot junction is located between the first infrared absorption member and the second end. Therefore, it is possible to improve the response speed and the sensitivity.

Furthermore, the infrared array sensor comprises the second infrared absorption member. The second infrared absorption member is disposed between the second slit and the second end. The hot junction is disposed between the second infrared absorption member and the first infrared absorption member. Therefore, it is possible to improve the response speed and the sensitivity.

In addition, the second slit is formed in a direction which intersects with the lengthwise direction of the cantilever. Therefore, it is possible to improve the response speed and the sensitivity.

In addition, the infrared array sensor **A** in this embodiment has the silicon nitride film **32** with incidence plane for the infrared, and is provided at its incidence plane of the silicon nitride film **32** with the n-type polysilicon layer **34,** p-type polysilicon layer **35,** the infrared absorption layers **39a, 39b,** and **39c,** and the wiring **139** for fault diagnosis. Therefore, this configuration makes it possible to prevent the silicon nitride film **32** from being etched to be thinned when the n-type polysilicon layer **34** and the p-type polysilicon layer 35 are formed. (That is, when the polysilicon layer patterning step is performed to etch the non-doped polysilicon layer for forming the n-type polysilicon layer and p-type polysiliconlayer, the overetching of the silicon nitride film **32** is prevented, whereby it is possible to prevent the silicon nitride film **32** from being thinned.) In addition, it is possible to uniform the balance of the stress in the thin film structural body **3a.** Therefore, it is possible to thin the infrared absorption member **33** and also to prevent the warpage of the sub-thin film structural body (cantilever) **3aa.** Therefore, the sensitivity is improved. In addition, there is a need to prevent the n-type polysilicon layer **34,** p-type polysilicon layer 35, the infrared absorption layers **39a, 39b,** and **39c,** and the wiring **139** for fault diagnosis from being etched by the etchant (such as TMAH solution) used in the recess forming step. Therefore, there is a need to employ the designing of disposing the above components so as not to be exposed to the inside surface of the first slit **13** and the second slit **14.**

In addition, the infrared array sensor **A** in this embodiment comprises the n-type polysilicon layer **34,** the p-type polysilicon layer **35,** the infrared absorption layer **39a, 39b,** and **39c,** and the wiring **139** for fault diagnosis. The n-type polysilicon layer **34,** the p-type polysilicon layer **35,** the infrared absorption layer **39a, 39b,** and **39c,** and the wiring **139** for fault diagnosis have the same thicknesses with respect to each other. Therefore, the uniformity of the balance of the stress of the sub-thin film structural body (cantilever) is improved. Therefore, it is possible to prevent the warpage of the sub-thin film structural body (cantilever) **3aa.**

In addition, the infrared array sensor **A** in this embodiment comprises the MOS transistors **4** with respect to each the image element **2,** and is configured to readout the output of the thermosensing portion **30.** Therefore, it is possible to reduce the number of the output pad **Vout.** Therefore, it is possible to achieve the downsizing and to reduce the cost.

### (SECOND EMBODIMENT)

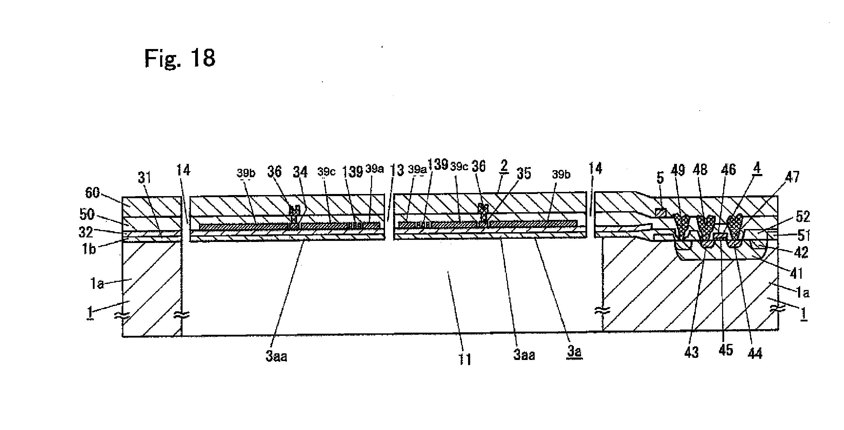

The infrared array sensor **A** in this embodiment comprises the basis components which are in common with the basic components of the first embodiment, the infrared array sensor **A** in this embodiment is different from that in the first embodiment in the recess **11** of the base **1** which is formed from the rear surface of the base **1,** shown in Fig. 18. In this embodiment, the components same as the components of the first embodiment are symbolized by the same reference numerals, and are omitted their explanations.

In the first embodiment, when the recess **11** is formed in the recess forming step, the etchant is provided to the first slit **13** and the second slit **14** from the front surface of the base **1.** Consequently, the silicon substrate **1a** is etched by means of the anisotropic etching using the dependency property of plane direction of the crystal of the etching speed of the silicon substrate **1a.** Consequently, the recess **11** is formed.

However, in the method of manufacturing the infrared array sensor **A** in this embodiment, the recess forming step for forming the recess **11** is performed to form the recess **11** to "a region where the recess **11** is to be formed in the silicon substrate **1a"** from the rear surface of the base **1,** by the means of the anisotropic etching with using the dry etching apparatus of induction coupled plasma (ICP) type.

According to the infrared array sensor in this embodiment, it is possible to prevent the heat transfer from the sub-thin film structural body (cantilever)**3aa** of the thin film structural body **3a** to the base **1.** This results in the improvement of the sensitivity

### (THIRD EMBODIMENT)

The infrared array sensor **A** in this embodiment comprises the basic components which are in common with the basic components of the first embodiment. The infrared array sensor **A** in this embodiment is different from that of the first embodiment in the recess having the inside surface being shaped to have a concave curve. In this embodiment, the components same as the components of the first embodiment are symbolized by the same reference numerals and are omitted their explanations.

In the first embodiment , in the recess forming step of forming the recess **11,** the recess **11** is formed by the anisotropic etching of using the dependency property of the plane direction of the crystal of the etching speed. However, in this embodiment, the recess **11** is formed by the isotropic etching.

Consequently, in the infrared array sensor **A** of this embodiment, the infrared which passes through the thin film structural body **3a** is reflected to the thin film structural body **3a** by the inside surface of the recess **11.** Therefore, it is possible to increase an amount of the infrared absorbed in the infrared absorption member **33,** whereby it is possible to improve the sensitivity.

### (FOURTH EMBODIMENT)

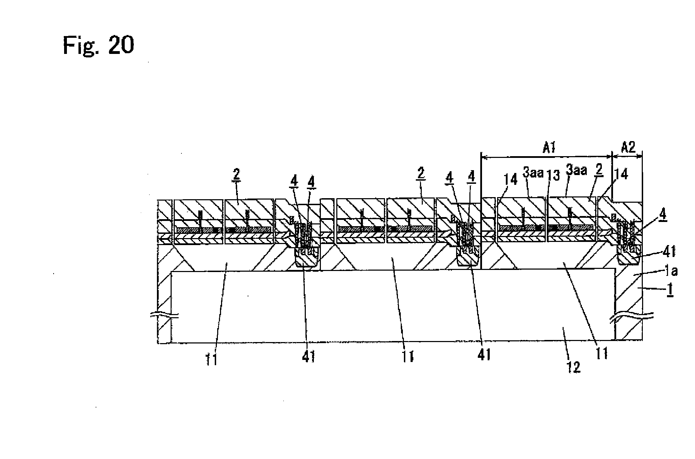

The infrared array sensor **A** in this embodiment comprises the basic components which are same as the components of the first embodiment. As will be understood from Fig. 20, the infrared array sensor **A** in this embodiment is different from that of the first embodiment in a feature that the base 1 is provided at its rear surface with an opening portion **12** which is configured to communicate with the a plurality of recesses **11.** In this embodiment, the components same as the components of the first embodiment and the third embodiment are symbolized by the same reference numerals and are omitted their explanations.

The opening portion **12** may be formed to "a region where the opening portion **12** is to be formed in the silicon substrate **1a"** by the anisotropic etching with using the dry etching device of ICP type.

Consequently, in the infrared array sensor **A** of this embodiment, it is possible to prevent the heat transfer from the sub-thin film structural body (cantilever **3aa)** of the thin film structural body **3a** to the base 1. Therefore, it is possible to improve the sensitivity.

### (FIFTH EMBODIMENT)

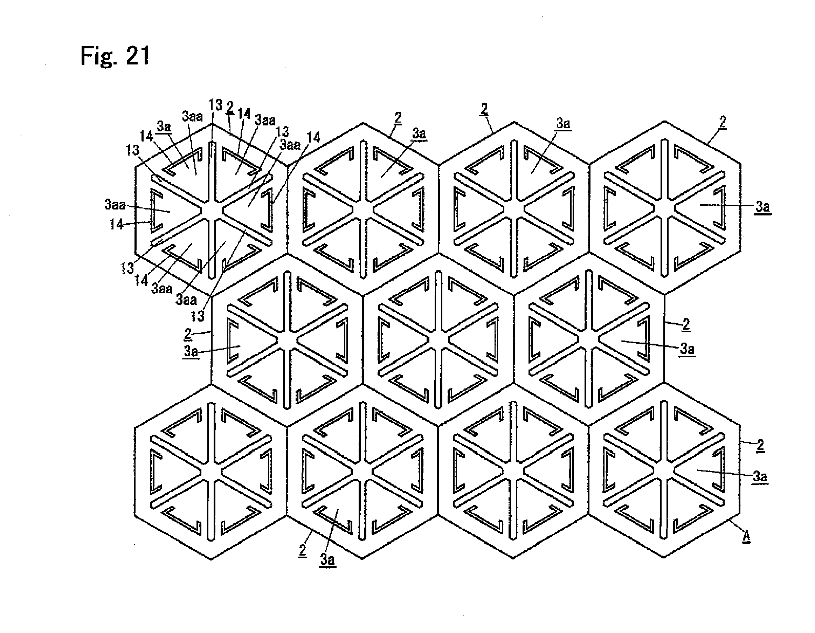

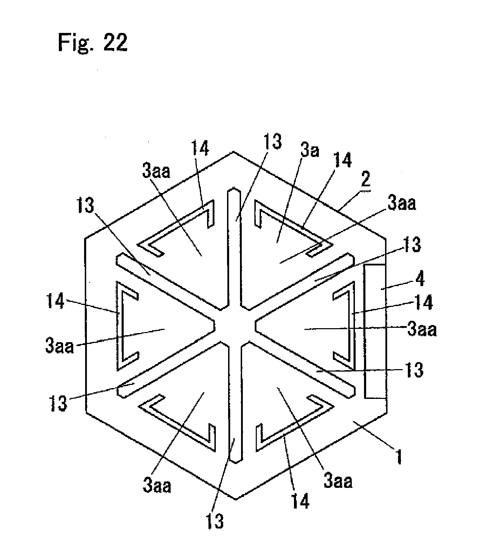

The infrared array sensor **A** in this embodiment has the basic components which are same as the basic components of the first embodiment to the fourth embodiment. As will be understood from Fig. 21 and Fig. 22, the difference is the image element **2** having a shape of hexagonal geometry in a planar view. In addition, the image elements **2** are arranged in the honeycomb geometry. In this embodiment, the components in common with that in the first embodiment to the fourth embodiment are symbolized by the same reference numerals, and are omitted their explanations.

Although Fig. 21 and Fig. 22 do not disclose, in this embodiment, the base **1** is provided at its surface with the recess **11.** The recess **11** has an opening having a hexagonal shape perpendicular to the thickness direction of the base **1.** Therefore, the recess **11** is surrounded by the rim which has a hexagonal shape. The rim having the hexagonal shape has six sides. The thin film structural body **3a** is disposed on the surface of the base **1** to cover the recess **11.** The thin film structural body **3a** is divided into six sub-thin film structural body **3aa** (cantilevers) by the slit. Each the sub thin films structural body **3aa** has a width which becomes gradually smaller from the first end toward the second end.

As explained in the above, the cantilever has the width which gradually becomes smaller toward the second end from the first end. Therefore, the heat capacity of the cantilever is reduced. According to the fact that the heat capacity of the cantilever is reduced, the temperature of the thermosensor **30a** is immediately varied when the heat absorbed in the infrared absorption member **33** is varied. Consequently, it is possible to improve the detection property of the thermosensor **30a.**

Furthermore, in the infrared array sensor **A** in this embodiment, each the sub thin film structural body (cantilever) **3aa** is prevented its deformation. In addition, it is possible to densely arrange the image element.

It is noted that the infrared array sensor **A** in the above embodiments comprises the image elements **2** each of which is provided with the MOS transistor **4.** However, the MOS transistor **4** is dispensable for the infrared array sensor.

## Claims

1. An infrared array sensor comprising:
a base having a surface, said base being provided at its surface with a plurality of recesses and a plurality of rims, said rims surround said recesses, respectively, each said recess has an inner periphery which is defined by each said rim;
an image element being arranged on said surface of said base such that said image element covers said recess,
said image element comprising a thin film structural body, a plurality of first infrared absorption layers, and a plurality of thermosensors,
said thin film structural body is provided with a first slit which penetrates through said thin film structural body from a rear surface of said thin film structural body to a front surface of said thin film structural body, whereby said first slit is configured to divide said thin film structural body into a plurality of cantilevers, said cantilevers are arranged along the rim,
each said cantilever has a length and a width, said cantilever having one lengthwise end being defined as a first end and the other lengthwise end being defined as a second end, said first end being fixed to said rim,
said first infrared absorption layer being held by said cantilever such that said first infrared absorption layer is located on an inside of said inner periphery,
said thermosensor being disposed on said cantilever,
wherein
when a temperature variation of said thermosensor being caused, said thermosensor generates an output signal corresponding to the temperature variation of said thermosensor.

2. The infrared array sensor as set forth in claim 1, wherein
all said thermosensors are electrically connected to each other to establish a predetermined connection relationship,
wherein
according to said predetermined connection relationship, all said thermosensors being configured to generate the output signal indicative of output variation corresponding to the temperature variation, the output variation indicated by the output signal of all said thermosensors being greater than the output variation indicated by the output signal generated in each said thermosensor.

3. The infrared array sensor as set forth in claim 1, wherien
said thermosensors are electrically connected to each other to establish a predetermined connection relationship, whereby said thermosensors being cooperative with each other to generate a second output signal when temperature variation of said thermosensor is caused,
the second output signal being greater than the output signal.

4. The infrared array sensor as set forth in claim 2 or claim 3, wherein
said thermosensor is realized by a thermopile.

5. The infrared array sensor as set forth in any one of claims 2 to 4, wherein
said predetermined relation is realized by a series connection.

6. The infrared array sensor as set forth in any one of claims 2 to 5, wherein
said recess is shaped to have a four-sided pyramid.

7. The infrared array sensor as set forth in any one of claims 2 to 5, wherein
said recess is formed from a rear surface of said base.

8. The infrared array sensor as set forth in any one of claims 2 to 5, wherein
said recess has an inside surface being realized by a concave curve.

9. The infrared array sensor as set forth in any one of claims 1 to 8, wherein
said base is provided at its remaining surface with an opening portion such that a plurality of the recesses are communicated with each other by the opening portion.

10. The infrared array sensor as set forth in any one of claims 1 to 9, wherein
said cantilever is provided with a second slit, said second slit being located between said first end and said second end,
said second slit being shaped to penetrate through said cantilever from said rear surface of said cantilever to said front surface of said cantilever,
said second slit being formed to overlap said recess in a thickness direction of said base, said first infrared absorption layer being disposed between said second slit and said second end,
said thermopile comprising a thermoelectric couple, a thermoelectric couple being provided at its one end with a hot junction and at its remaining end with a cold junction, said hot junction being located between said second end and said second slit,
said cold junction being disposed between said first end and said second slit.

11. The infrared array sensor as set forth in claim 10, wherein
said hot junction being disposed between said first infrared absorption layer and said second slit.

12. The infrared array sensor as set forth in claim 11, wherein
said image element further comprises a second infrared absorption layer, said second infrared absorption layer being disposed between said second slit and said second end, said hot junction being disposed between said second infrared absorption layer and said first infrared absorption layer.

13. The infrared array sensor as set forth in any one of claims 1 to 12, wherein
said second slit extends in a direction which crosses with the lengthwise direction of said cantilever.

14. The infrared array sensor as set forth in any one of claims 1 to 13, wherein
the width of said cantilever gradually becomes smaller from said first end toward said second end.

15. The infrared array sensor as set forth in claim 14, wherein
said recess has an opening which is perpendicular to a thickness direction,
said opening being shaped to have a hexagonal shape, whereby said rim has six sides, said first ends of said cantilevers being attached to said six sides, respectively,
said cantilever extending toward a center of said opening,
each said cantilever being spaced from adjacent cantilever by said first slit.
